# EUROPEAN PATENT APPLICATION

(11) **EP 4 697 917 A1**
(43) Date of publication of application: **18.02.2026**
(21) Application number: 24789074.2
(22) Date of filing: 12.04.2024
(51) Int. Cl.: H10K 85/60, H10K 50/16, H10K 50/15, H10K 50/11

(54) **LIGHT-EMITTING DEVICE AND MANUFACTURING METHOD THEREFOR**

(30) Priority: 14.04.2023 KR 20230049664
(71) Applicant: Samsung Display Co., Ltd., Yongin-si, Gyeonggi-do 17113 (KR)
(72) Inventor: KIM, Heung Gyu, Yongin-si Gyeonggi-do 17113 (KR); LIM, Jung Hwan, Yongin-si Gyeonggi-do 17113 (KR); BAK, Ji Yun, Yongin-si Gyeonggi-do 17113 (KR); SHIN, Dong Woo, Yongin-si Gyeonggi-do 17113 (KR); HA, Jae Kook, Yongin-si Gyeonggi-do 17113 (KR)
(74) Representative: Marks & Clerk LLP
(86) International application number: PCT/KR2024/004939
(87) International publication number: WO 2024/215133

(57) **Abstract**

A light-emitting element includes a first electrode, a second electrode facing the first electrode, a light-emitting layer disposed between the first electrode and the second electrode, a first electron auxiliary layer disposed between the first electrode and the light-emitting layer, and a functional layer disposed between the light-emitting layer and the first electron auxiliary layer and including a compound having a carboxyl group.

## Description

### Technical Field

The present invention relates to a display device. More specifically, the present invention relates to a light-emitting element included in a display device and a method for manufacturing the light-emitting element.

### Description of the Related Art

The light-emitting element is an element that emits light from a light-emitting layer interposed between two opposing electrodes when a voltage is applied to the electrodes. Specifically, when a voltage is applied to the two electrodes, electrons and holes injected from the electrodes meet each other in the light-emitting layer to form excitons. As the excitons transition from an excited energy state to a relatively lower energy state, light of a predetermined wavelength is emitted.

Since the light-emitting element should have as many electrons and holes as possible meet in the light-emitting layer to form excitons, it is desirable to adjust the movement characteristics of holes and electrons so that holes and electrons injected from anode and cathode meet well in the light-emitting layer. Therefore, the light-emitting element may include organic layers that improve the movement characteristics of electrons or holes on or under the light-emitting layer.

In particular, an electron transport layer that improves electron transfer characteristics may be provided. The electron transport layer consists of various materials, and many electron transport materials are under research to supply electrons having appropriate transfer characteristics even at a relatively low driving voltage.

### Detailed Explanation of the Invention

### Technical Purpose

An object of the present invention is to provide a light-emitting element with improved efficiency and lifetime.

Another object of the present invention is to provide a method of manufacturing the light-emitting element.

However, the object of the present invention is not limited to this object, and may be expanded in various ways without departing from the spirit and scope of the present invention.

### Technical Solution

A light-emitting element in an embodiment may include a first electrode, a second electrode facing the first electrode, a light-emitting layer disposed between the first electrode and the second electrode, a first electron auxiliary layer disposed between the first electrode and the light-emitting layer, and a functional layer disposed between the light-emitting layer and the first electron auxiliary layer and including a compound having a carboxyl group.

In an embodiment, the compound having the carboxyl group may include any one of following compounds: 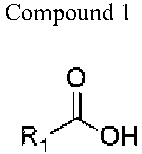 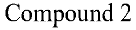 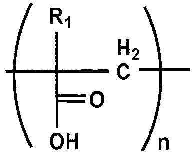 wherein in compound 1 and compound 2, R1 each independently represents

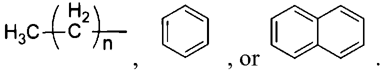

In an embodiment, the first electron auxiliary layer may include inorganic metal nano particles.

In an embodiment, the first electron auxiliary layer may include at least one selected from TiO₂, ZnO, ZnMgO, ZnAlO, and SnO₂.

In an embodiment, the light-emitting element may further include a second electron auxiliary layer disposed on the first electron auxiliary layer.

In an embodiment, the first electron auxiliary layer may be an electron injection layer, and the second electron auxiliary layer may be an electron transport layer.

In an embodiment, the first electron auxiliary layer may include ZnO, and the second electron auxiliary layer may include ZnMgO.

In an embodiment, the functional layer may be disposed between the first electron auxiliary layer and the second electron auxiliary layer.

In an embodiment, the functional layer may be in direct contact with the first electron auxiliary layer.

In an embodiment, the functional layer may be disposed between the second electron auxiliary layer and the light-emitting layer.

In an embodiment, the functional layer may be in direct contact with the second electron auxiliary layer.

In an embodiment, the light-emitting layer may include a quantum dot.

In an embodiment, the light-emitting layer may include an organic material.

In an embodiment, the light-emitting element may further include a hole auxiliary layer disposed between the second electrode and the light-emitting layer.

A method of manufacturing a light-emitting element in an embodiment may include forming a first electrode, forming a first electron auxiliary layer on the first electrode, forming a functional layer including a compound having a carboxyl group on the first electron auxiliary layer, forming a light-emitting layer on the functional layer, and forming a second electrode on the light-emitting layer.

In an embodiment, the forming the functional layer may include forming a preliminary functional layer including a compound having an ester group on the first electron auxiliary layer and heat-treating the preliminary functional layer.

In an embodiment, the compound having the ester group may include any one of following compounds: 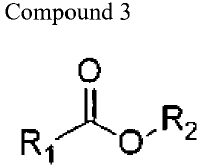 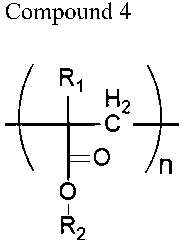 wherein in compound 3 and compound 4,
R1 each independently represents 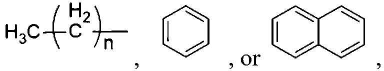 and
R2 each independently represents

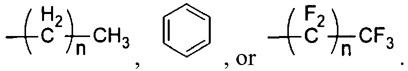

In an embodiment, the method may further include forming a second electron auxiliary layer on the first electron auxiliary layer, and the forming the second electron auxiliary layer may be performed before the forming the light-emitting layer.

In an embodiment, the functional layer may be formed on the first electron auxiliary layer, and the second electron auxiliary layer may be formed on the functional layer.

In an embodiment, the functional layer may be formed on the second electron auxiliary layer.

### Advantageous Effects

In the display device in embodiments of the present invention, since a light-emitting element is disposed between the first electron auxiliary layer and the second auxiliary layer and further includes the functional layer including a compound having a carboxyl group, the number of trap sites on the upper surface of the first electron auxiliary layer may be reduced. That is, by forming the functional layer on the upper surface of the first electron auxiliary layer, the number of trap sites on the upper surface of the first electron auxiliary layer may be reduced. By reducing the number of trap sites on the upper surface of the first electron auxiliary layer, electron injection efficiency into a light-emitting layer may be increased. Accordingly, characteristics of the light-emitting element may be improved.

Since the functional layer is formed by heat-treating a preliminary functional layer including a compound having an ester group, corrosion of an inkjet device forming the functional layer may be prevented. Specifically, when the compound having a carboxylic acid contacts the inkjet device, the inkjet device may be corroded. Therefore, corrosion of the inkjet device may be prevented by forming the preliminary functional layer using the compound having an ester group which is relatively stable, and efficiency of the light-emitting element may be improved by subsequently heat-treating the preliminary functional layer to form the functional layer.

However, the effects of the present invention are not limited to the above effects, and may be expanded in various ways without departing from the spirit and scope of the present invention.

### Brief Description of the Drawings

FIG. 1 is a cross-sectional view illustrating an embodiment of a light-emitting element.
FIG. 2 is a cross-sectional view illustrating an embodiment of a display device.
FIG. 3 is a cross-sectional view illustrating an embodiment of a light-emitting element.
FIGS. 4 to 7 are views illustrating an embodiment of a method of manufacturing a light-emitting element.
FIGS. 8 to 10 are views illustrating an embodiment of a method of manufacturing a light-emitting element.
FIG. 11 is a graph showing current density over voltage.
FIG. 12 is a graph showing luminance over time.

### Best Mode for Carrying Out the Invention

Hereinafter, embodiments of the present invention will be explained in detail with reference to the accompanying drawings. The same reference numerals are used for the same components in the drawings, and redundant descriptions of the same components will be omitted.

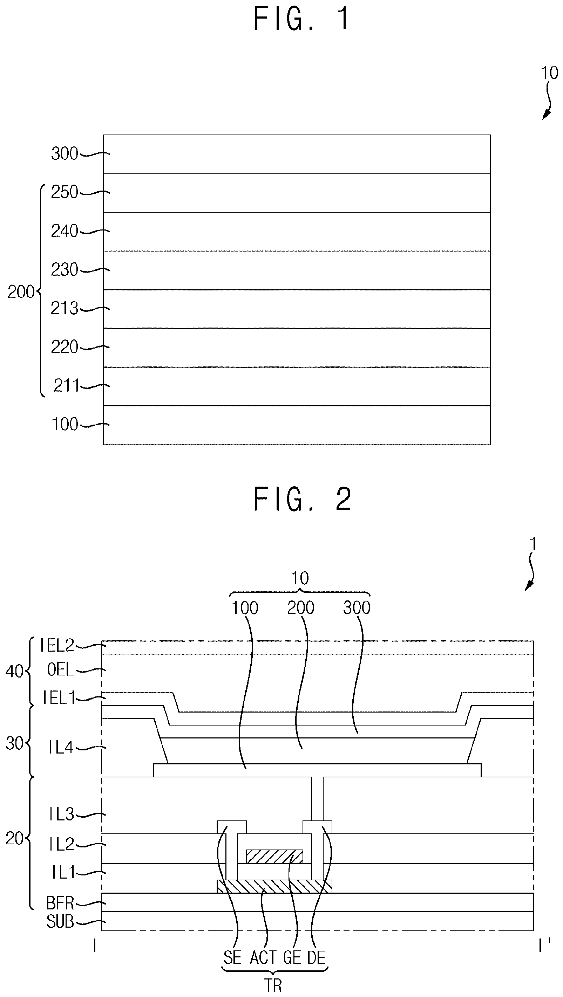

FIG. 1 is a cross-sectional view illustrating an embodiment of a light-emitting element.

Referring to FIG. 1, the light-emitting element 10 may include a first electrode 100, an intermediate layer 200, and a second electrode 300.

In an embodiment, the first electrode 100 may be a cathode. The first electrode 100 may have light-transmitting or reflecting properties. In an embodiment, the first electrode 100 may include a metal and/or a reflective conductive material, for example.

In an embodiment, the second electrode 300 may face the first electrode 100. In an embodiment, the second electrode 300 may be disposed on the first electrode 100, for example. The second electrode 300 may be an anode. The second electrode 300 may have light-transmitting or reflecting properties. In an embodiment, the second electrode 300 may include a metal and/or a light-transmitting conductive material, for example.

The intermediate layer 200 may be disposed between the first electrode 100 and the second electrode 300. That is, the intermediate layer 200 may be disposed on the first electrode 100 and disposed under the second electrode 300. The intermediate layer 200 may include a light-emitting layer 230, an electron auxiliary layer, a hole auxiliary layer, and a functional layer 220.

The light-emitting layer 230 may be disposed between the first electrode 100 and the second electrode 300. That is, the light-emitting layer 230 may be disposed on the first electrode 100 and disposed under the second electrode 300. The light-emitting layer 230 may include organic and/or inorganic light-emitting materials. In an embodiment, the light-emitting layer 230 may include quantum dots. However, the present invention is not limited thereto, and in another embodiment, the light-emitting layer 230 may include an organic material.

The electron auxiliary layer may be disposed between the first electrode 100 and the light-emitting layer 230. The electron auxiliary layer may include inorganic metal nano particles. In an embodiment, the inorganic metal nano particles that may be used as the electron auxiliary layer may include TiO₂, ZnO, ZnMgO, ZnAlO, SnO₂, or the like, for example. These may be used alone or in any combinations with each other.

The electron auxiliary layer may include a first electron auxiliary layer 211 and a second electron auxiliary layer 213. The first electron auxiliary layer 211 may be disposed between the first electrode 100 and the light-emitting layer 230. The second electron auxiliary layer 213 may be disposed on the first electron auxiliary layer 211 and may be disposed under the light-emitting layer 230.

In an embodiment, the first electron auxiliary layer 211 may be an electron injection layer, and the second electron auxiliary layer 213 may be an electron transport layer, for example. Also, the first electron auxiliary layer 211 may include ZnO, and the second electron auxiliary layer 213 may include ZnMgO. However, the present invention is not limited thereto.

The hole auxiliary layer may be disposed between the second electrode 300 and the light-emitting layer 230. The hole auxiliary layer may include a first hole auxiliary layer 240 and a second hole auxiliary layer 250. The second hole auxiliary layer 250 may be disposed on the first hole auxiliary layer 240. In an embodiment, the first hole auxiliary layer 240 may be a hole transport layer, and the second hole auxiliary layer 250 may be a hole injection layer, for example.

In an embodiment, the functional layer 220 may be disposed between the light-emitting layer 230 and the first electron auxiliary layer 211. In an embodiment, the functional layer 220 may be disposed between the first electron auxiliary layer 211 and the second electron auxiliary layer 213, for example. In this case, the functional layer 220 may be in direct contact with the first electron auxiliary layer 211. That is, the functional layer 220 may be in direct contact with an upper surface of the first electron auxiliary layer 211.

In an embodiment, the functional layer 220 may include a compound having a carboxyl group. The compound having the carboxyl group may include any one of following compounds: 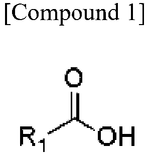 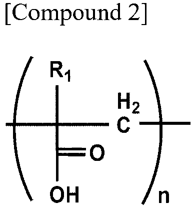 where in compound 1 and compound 2, R1 may each independently represent

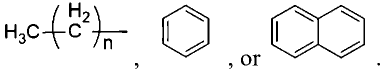

In an embodiment, since the light-emitting element 10 further includes the functional layer 220 disposed between the first electron auxiliary layer 211 and the second electron auxiliary layer 213 and including the compound having a carboxyl group, the number of trap sites on the upper surface of the first electron auxiliary layer 211 may be reduced. That is, by forming the functional layer 220 on the upper surface of the first electron auxiliary layer 211, the number of trap sites on the upper surface of the first electron auxiliary layer 211 may be reduced. By reducing the number of trap sites on the upper surface of the first electron auxiliary layer 211, electron injection efficiency into the light-emitting layer 230 may be increased. Accordingly, characteristics of the light-emitting element 10 may be improved.

FIG. 2 is a cross-sectional view illustrating an embodiment of a display device. FIG. 2 may be a cross-sectional view of a display device including the light-emitting element 10 of FIG. 1, for example.

Referring to FIGS. 1 and 2, a display device 1 may include a substrate SUB, a circuit element layer 20, a light-emitting element layer 30, and an encapsulation layer 40.

The circuit element layer 20 may be disposed on the substrate SUB, and may include a buffer layer BFR, at least one transistor TR, a first insulating layer IL1, a second insulating layer IL2, and a third insulating layer IL3. The transistor TR may include an active layer ACT, a gate electrode GE, a source electrode SE, and a drain electrode DE. The light-emitting element layer 30 may be disposed on the circuit element layer 20 and may include a fourth insulating layer IL4 and the light-emitting element 10.

The substrate SUB may include a transparent or opaque material. In an embodiment, the substrate SUB may be a flexible substrate including or consisting of polyimide or the like, for example. The flexible substrate may have a structure in which polyimide layers and barrier layers are alternately stacked. In another embodiment, the substrate SUB may be a rigid substrate including or consisting of quartz, glass, or the like.

The buffer layer BFR may be disposed on the substrate SUB. The buffer layer BFR may prevent diffusion of metal atoms or impurities from the substrate SUB into the active layer ACT.

The active layer ACT may be disposed on the buffer layer BFR. The active layer ACT may be divided into a source region and a drain region doped with impurities and a channel region between the source region and the drain region.

The first insulating layer IL1 may be disposed on the buffer layer BFR. The first insulating layer IL1 may cover the active layer ACT and may be formed to have substantially a constant thickness along a profile of the active layer ACT. However, it is not limited thereto. In an embodiment, the first insulating layer IL1 may include an inorganic material.

The gate electrode GE may be disposed on the first insulating layer IL1. In an embodiment, the gate electrode GE may overlap the channel region of the active layer ACT.

The second insulating layer IL2 may be disposed on the first insulating layer IL1. In addition, the second insulating layer IL2 may cover the gate electrode GE and may be disposed with substantially a constant thickness along a profile of the gate electrode GE. However, it is not limited thereto.

The source electrode SE and the drain electrode DE may be disposed on the second insulating layer IL2. The source electrode SE may contact the source region of the active layer ACT through a first contact hole defined in the first and second insulating layers IL1 and IL2. The drain electrode DE may contact the drain region of the active layer ACT through a second contact hole defined in the first and second insulating layers IL1 and IL2.

The third insulating layer IL3 may be disposed on the second insulating layer IL2. In addition, the third insulating layer IL3 may cover the source and drain electrodes SE and DE, and has a substantially flat upper surface without creating a step around the source and drain electrodes SE and DE. In an embodiment, the third insulating layer IL3 may include an organic material, for example.

The light-emitting element 10 may be disposed on the third insulating layer IL3. The light-emitting element 10 may include the first electrode 100, the intermediate layer 200, and the second electrode 300.

The first electrode 100 may be disposed on the third insulating layer IL3. The first electrode 100 may contact the source electrode SE or the drain electrode DE through a third contact hole defined in the third insulating layer IL3. Through this, the first electrode 100 may be connected to the transistor TR.

The fourth insulating layer IL4 may be disposed on the third insulating layer IL3, and an opening exposing an upper surface of the first electrode 100 may be defined in the fourth insulating layer IL4. In an embodiment, the fourth insulating layer IL4 may include an organic material or an inorganic material, for example.

A spacer may be further disposed on the fourth insulating layer IL4. In an embodiment, the spacer may include an organic material or an inorganic material, for example. The spacer may maintain a gap between the encapsulation layer 40 and the substrate SUB.

The intermediate layer 200 may be disposed on the first electrode 100. The intermediate layer 200 may be disposed in the opening defined in the fourth insulating layer IL4.

The second electrode 300 may cover the intermediate layer 200 and may be disposed on the fourth insulating layer IL4 and the spacer.

The encapsulation layer 40 may cover the light-emitting element layer 30 and may be disposed on the light-emitting element layer 30. The encapsulation layer 40 may prevent penetration of moisture and oxygen into the light-emitting element 10 from the outside. In an embodiment, the encapsulation layer 40 may include a first inorganic encapsulation layer IEL1, an organic encapsulation layer OEL, and a second inorganic encapsulation layer IEL2, for example.

The first inorganic encapsulation layer IEL1 may be disposed on the second electrode 300 with substantially a constant thickness along a profile of the second electrode 300. The organic encapsulation layer OEL may be disposed on the first inorganic encapsulation layer IEL1, and may have a substantially flat upper surface without creating a step around the first inorganic encapsulation layer IEL1. The second inorganic encapsulation layer IEL2 may be disposed on the organic encapsulation layer OEL.

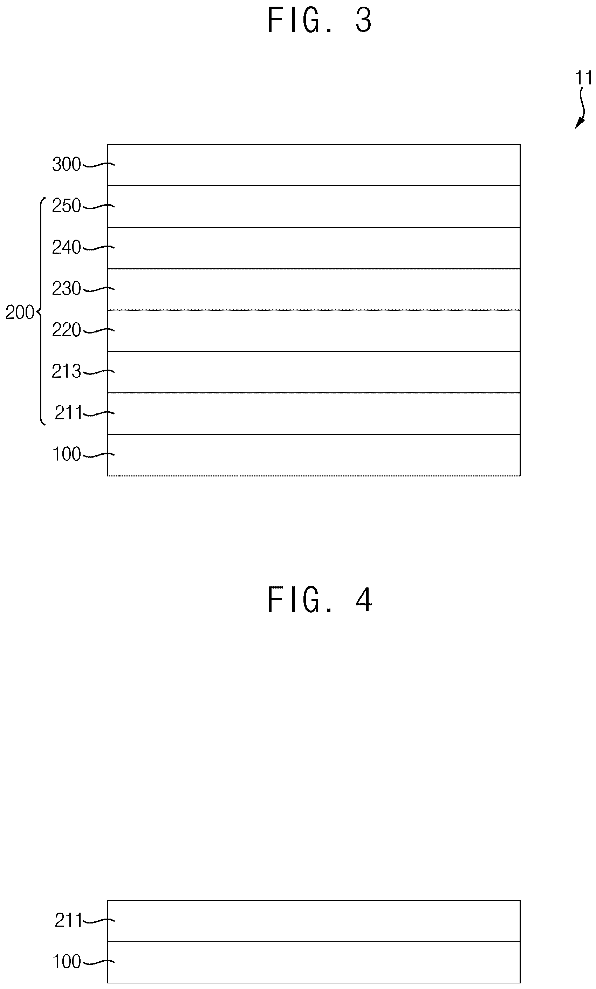

FIG. 3 is a cross-sectional view illustrating an embodiment of a light-emitting element.

In an embodiment, a light-emitting element 11 of FIG. 3 may be substantially same as the light-emitting element 10 described with reference to FIGS. 1 and 2 except for a stacking order of the functional layer 220 and the second electron auxiliary layer 213, for example. Accordingly, redundant descriptions may be omitted or simplified.

Referring to FIG. 3, the light-emitting element 11 may include a first electrode 100, an intermediate layer 200, and a second electrode 300. The intermediate layer 200 may include a light-emitting layer 230, an electron auxiliary layer, a hole auxiliary layer, and a functional layer 220.

In an embodiment, the functional layer 220 may be disposed between the light-emitting layer 230 and the first electron auxiliary layer 211. In an embodiment, the functional layer 220 may be disposed between the second electron auxiliary layer 213 and the light-emitting layer 230, for example. In this case, the functional layer 220 may be in direct contact with the second electron auxiliary layer 213. That is, the functional layer 220 may be in direct contact with an upper surface of the second electron auxiliary layer 213.

In an embodiment, the functional layer 220 may include a compound having a carboxyl group. The compound having the carboxyl group may include any one of following compounds: 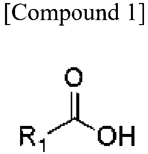 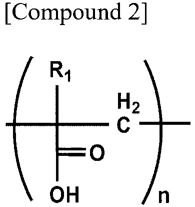 where in compound 1 and compound 2, R1 may each independently represent

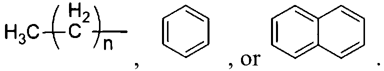

In an embodiment, since the light-emitting element 11 further includes the functional layer 220 disposed between the second electron auxiliary layer 213 and the light-emitting layer 230 and including the compound having a carboxyl group, the number of trap sites on the upper surface of the second electron auxiliary layer 213 may be reduced. That is, by forming the functional layer 220 on the upper surface of the second electron auxiliary layer 213, the number of trap sites on the upper surface of the second electron auxiliary layer 213 may be reduced. By reducing the number of trap sites on the upper surface of the second electron auxiliary layer 213, electron injection efficiency into the light-emitting layer 230 may be increased. Accordingly, characteristics of the light-emitting element 11 may be improved.

FIGS. 4 to 7 are views illustrating an embodiment of a method of manufacturing a light-emitting element.

In an embodiment, a method of manufacturing the light-emitting element described with reference to FIGS. 4 to 7 may be a method of manufacturing the light-emitting element 10 described with reference to FIG. 1, for example. Accordingly, redundant descriptions may be omitted or simplified.

Referring to FIG. 4, the first electrode 100 may be formed. The first electrode 100 may be a cathode. In an embodiment, the first electrode 100 may include or consist of a metal and/or a reflective conductive material, for example.

The first electron auxiliary layer 211 may be formed on the first electrode 100. The first electron auxiliary layer 211 may include or consist of inorganic metal nano particles. In embodiments, the inorganic metal nano particles that may be used as the first auxiliary layer 211 may include TiO₂, ZnO, ZnMgO, ZnAlO, SnO₂, or the like. These may be used alone or in any combinations with each other. In an embodiment, the first electron auxiliary layer 211 may include or consist of ZnO, for example. However, the present invention is not limited thereto.

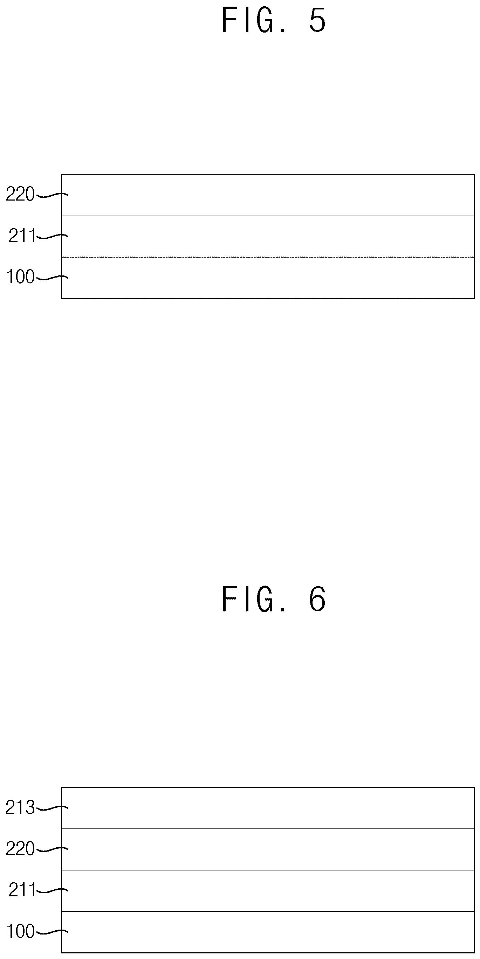

Referring further to FIG. 5, the functional layer 220 including the compound having a carboxyl group may be formed on the first electron auxiliary layer 211. The functional layer 220 may be formed by an inkjet process.

Specifically, a preliminary functional layer may be formed on the first electron auxiliary layer 211. The preliminary functional layer may include or consist of a compound having an ester group. The compound having the ester group may include any one of following compounds: 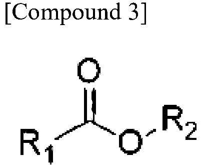 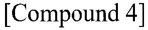 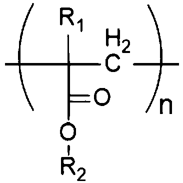 where in compound 3 and compound 4, R1 may each independently represent 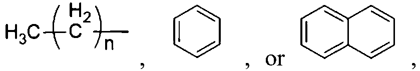 and R2 may each independently represent

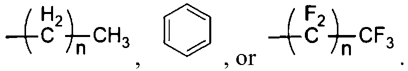

Thereafter, the preliminary functional layer may be heat-treated. As the preliminary functional layer is heat-treated, an ester group may be hydrolyzed. The ester group may be hydrolyzed to form carboxylic acid and alcohol. The alcohol may be removed by heat, and only the carboxylic acid may remain to form the functional layer 220 including the compound having a carboxyl group. The compound having the carboxyl group may include any one of following compounds: 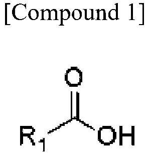 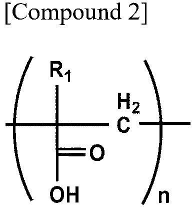 where in compound 1 and compound 2, R1 may each independently represent

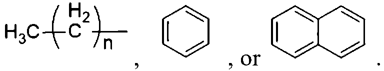

Referring further to FIG. 6, the second electron auxiliary layer 213 may be formed on the functional layer 220. The second electron auxiliary layer 213 may include or consist of inorganic metal nano particles. In embodiments, the inorganic metal nano particles that may be used as the second electron auxiliary layer 213 may include TiO₂, ZnO, ZnMgO, ZnAlO, SnO₂, or the like. These may be used alone or in any combinations with each other. In an embodiment, the second electron auxiliary layer 213 may include or consist of ZnMgO, for example. However, the present invention is not limited thereto.

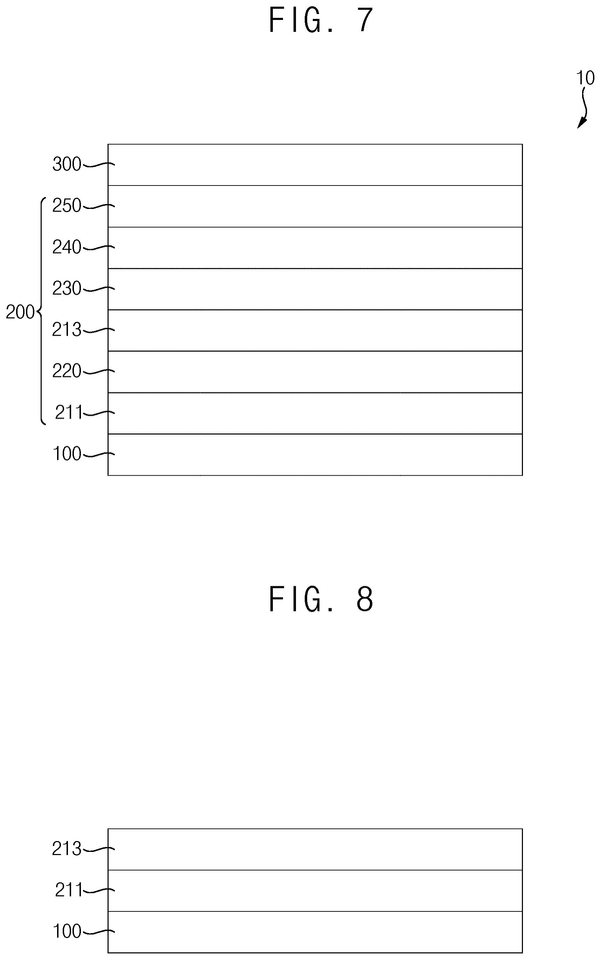

Referring further to FIG. 7, the light-emitting layer 230 may be formed on the second electron auxiliary layer 213. The light-emitting layer 230 may include or consist of organic and/or inorganic light-emitting materials. In an embodiment, the light-emitting layer 230 may include quantum dots. However, the present invention is not limited thereto, and in another embodiment, the light-emitting layer 230 may include or consist of an organic material.

The first hole auxiliary layer 240 may be formed on the light-emitting layer 230. The second hole auxiliary layer 250 may be formed on the first hole auxiliary layer 240. The second electrode 300 may be formed on the second hole auxiliary layer 250. The second electrode 300 may be an anode. In an embodiment, the second electrode 300 may include or consist of a metal and/or a light-transmitting conductive material, for example. Thus, the light-emitting element 10 may be formed.

In an embodiment, the functional layer 220 may be formed by heat-treating the preliminary functional layer including the compound having an ester group, thereby preventing corrosion of an inkjet device forming the functional layer 220. Specifically, when the compound having a carboxylic acid contacts the inkjet device, the inkjet device may be corroded. Therefore, corrosion of the inkjet device may be prevented by forming the preliminary functional layer using the compound having an ester group which is relatively stable, and efficiency of the light-emitting element may be improved by heat-treating the preliminary functional layer to form the functional layer 220.

FIGS. 8 to 10 are views illustrating an embodiment of a method of manufacturing a light-emitting element.

In an embodiment, a manufacturing method of the light-emitting element described with reference to FIGS. 8 to 10 may be substantially same as the manufacturing method of the light-emitting element described with reference to FIGS. 4 to 7 except for a formation order of the functional layer 220 and the second electron auxiliary layer 213, for example. In addition, the method of manufacturing the light-emitting element described with reference to FIGS. 8 to 10 may be a method of manufacturing the light-emitting element 11 described with reference to FIG. 3. Accordingly, redundant descriptions may be omitted or simplified.

Referring to FIG. 8, the first electrode 100 may be formed. The first electron auxiliary layer 211 may be formed on the first electrode 100. The second electron auxiliary layer 213 may be formed on the first electron auxiliary layer 211.

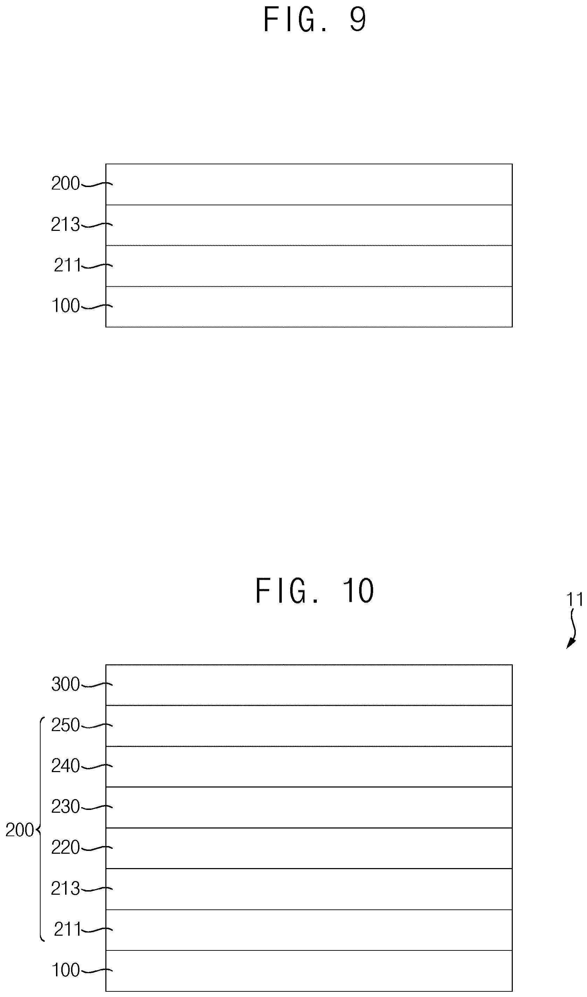

Referring further to FIG. 9, the functional layer 220 including the compound having a carboxyl group may be formed on the second electron auxiliary layer 213. The functional layer 220 may be formed by an inkjet process.

Specifically, a preliminary functional layer may be formed on the second electron auxiliary layer 213. The preliminary functional layer may include or consist of a compound having an ester group. The compound having the ester group may include any one of the following compounds: 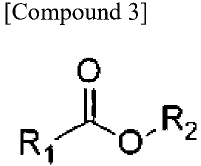 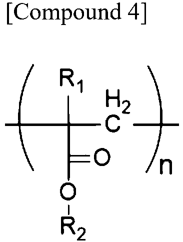 where in compound 3 and compound 4, R1 may each independently represent 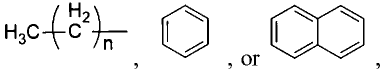 and R2 may each independently represent

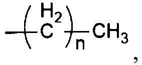

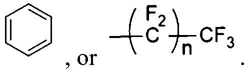

Thereafter, the preliminary functional layer may be heat-treated. As the preliminary functional layer is heat-treated, an ester group may be hydrolyzed. The ester group may be hydrolyzed to form carboxylic acid and alcohol. The alcohol may be removed by heat, and only the carboxylic acid may remain to form the functional layer 220 including the compound having a carboxyl group. The compound having the carboxyl group may include any one of following compounds: 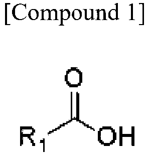 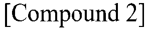 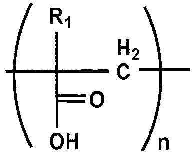 where in compound 1 and compound 2, R1 may each independently represent

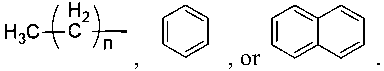

Referring further to FIG. 10, the light-emitting layer 230 may be formed on the functional layer 220. The first hole auxiliary layer 240 may be formed on the light-emitting layer 230. The second hole auxiliary layer 250 may be formed on the first hole auxiliary layer 240. The second electrode 300 may be formed on the second hole auxiliary layer 250. Thus, the light-emitting element 11 may be formed.

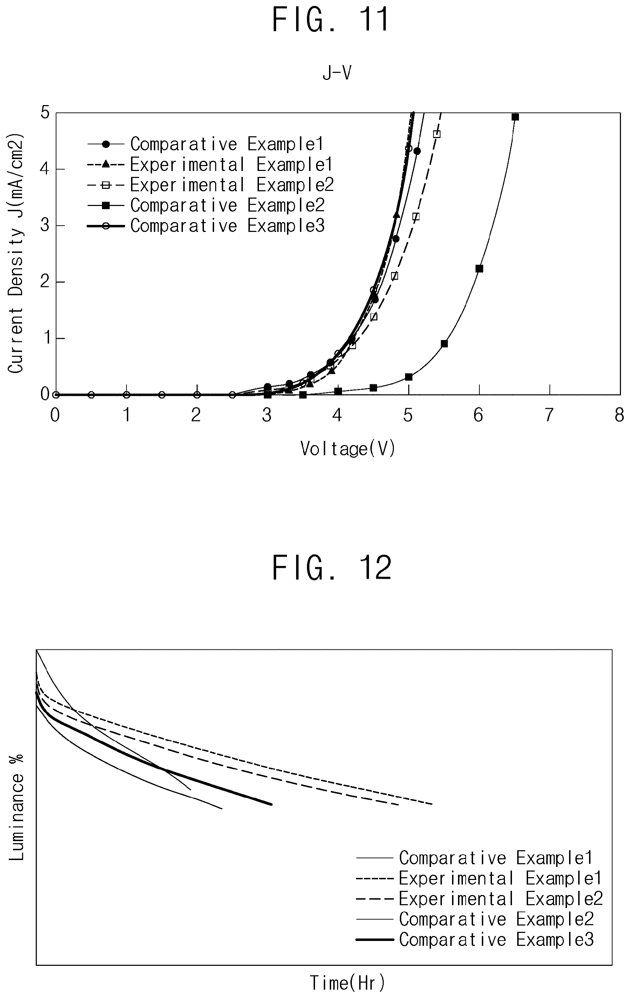

Hereinafter, effects of the present invention will be further described with reference to Table 1, FIGS. 11 and 12.

### Manufacturing of light-emitting element

### [Comparative Example 1]

A 15 ohm per square centimeter (Ω/cm²) indium tin oxide ("ITO") glass substrate (50 millimeter (mm) × 50 mm × 0.7 mm) was ultrasonically cleaned in isopropyl alcohol and pure water for 30 minutes to prepare a first electrode. 1 milliliter (mL) of an electron auxiliary layer composition, 1 mL of a light-emitting layer composition, 1 mL of a first hole auxiliary layer composition, and 1 mL of a second hole auxiliary layer composition were coated on the first electrode by a solution process using spin coating.

Specifically, a ZnO composition was spin-coated on the first electrode which is cleaned to form a film having a thickness of 30 nanometers (nm), and then baked at 200 degrees Celsius (°C) for 10 minutes to form a first electron auxiliary layer. A ZnMgO composition was spin-coated on the first electron auxiliary layer to form a film having a thickness of 20 nm, and then baked at 200 °C for 10 minutes to form a second electron auxiliary layer. A light-emitting layer was spin-coated on the second electron auxiliary layer to form a film having a thickness of 20 nm, and then baked at 100 °C for 10 minutes to form the light-emitting layer. A first hole auxiliary layer composition was spin-coated on the layer formed up to the light-emitting layer to form a film having a thickness of 20 nm, and then baked at 100 °C for 10 minutes to form a first hole auxiliary layer. A second hole auxiliary layer composition was spin-coated on the first hole auxiliary layer to form a film having a thickness of 10 nm, and then baked at 100 °C for 10 minutes to form a second hole auxiliary layer. Subsequently, AgMg was vacuum deposited on the second hole auxiliary layer to form a second electrode having a thickness of 10 nm to manufacture a light-emitting element. As a deposition machine, a Suicel plus 200 deposition machine of Sunic System was used. Driving voltage, luminous efficiency, and color coordinates of the light-emitting element manufactured in the comparative example were measured using a Keithley SMU 236 and a luminance meter PR650.

### [Experimental Example 1]

A 15 Ω/cm ² ITO glass substrate (50 mm × 50 mm × 0.7 mm) was ultrasonically cleaned in isopropyl alcohol and pure water for 30 minutes to prepare a first electrode. 1 mL of an electron auxiliary layer composition, 1 mL of a functional layer composition, 1 mL of a light-emitting layer composition, 1 mL of a first hole auxiliary layer composition, and 1 mL of a second hole auxiliary layer composition were coated on the first electrode by a solution process using spin coating.

Specifically, a ZnO composition was spin-coated on the first electrode which is cleaned to form a film having a thickness of 30 nm, and then baked at 200° C for 10 minutes to form a first electron auxiliary layer. A functional layer composition was spin-coated on the first electron auxiliary layer to form a film having a thickness of 10 nm, and then baked at 150 °C. for 10 minutes to form a functional layer. A ZnMgO composition was spin-coated on the functional layer to form a film having a thickness of 20 nm, and then baked at 200 °C for 10 minutes to form a second electron auxiliary layer. A light-emitting layer was spin-coated on the second electron auxiliary layer to form a film having a thickness of 20 nm, and then baked at 100 °C for 10 minutes to form the light-emitting layer. The first hole auxiliary layer composition was spin-coated on the layer formed up to the light-emitting layer to form a film having a thickness of 20 nm, and then baked at 100 °C for 10 minutes to form a first hole auxiliary layer. The second hole auxiliary layer composition was spin-coated on the first hole auxiliary layer to form a film having a thickness of 10 nm, and then baked at 100 °C for 10 minutes to form a second hole auxiliary layer. Subsequently, AgMg was vacuum deposited on the second hole auxiliary layer to form a second electrode having a thickness of 10 nm to manufacture a light-emitting element. As a deposition machine, a Suicel plus 200 deposition machine of Sunic System was used. Driving voltage, luminous efficiency, and color coordinates of the light-emitting element manufactured in the Experimental Example 1were measured using a Keithley SMU 236 and a luminance meter PR650.

The functional layer composition included any one of the following compounds, and the electron auxiliary layer composition included at least one of TiO₂, ZnO, ZnMgO, ZnAlO, and SnO₂, 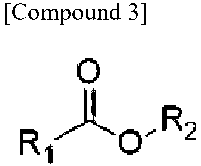 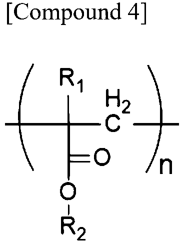 where in compound 3 and compound 4, R1 may each independently represent 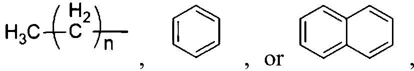 and R2 may each independently represent

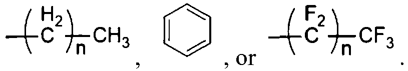

### [Experimental Example 2]

A light-emitting element was manufactured in a same manner as in Experimental Example 1, except that a formation order of the functional layer and the second electron auxiliary layer was changed.

That is, the light-emitting element of Experimental Example 2 was manufactured by forming the first electrode, the first electron auxiliary layer on the first electrode, the second electron auxiliary layer on the first electron auxiliary layer, the functional layer on the second electron auxiliary layer, the light-emitting layer on the functional layer, the first hole auxiliary layer on the light-emitting layer, the second hole auxiliary layer on the first hole auxiliary layer, and the second electrode on the second hole auxiliary layer.

### [Comparative Example 2]

A 15 Ω/cm ² ITO glass substrate (50 mm × 50 mm × 0.7 mm) was ultrasonically cleaned in isopropyl alcohol and pure water for 30 minutes to prepare a first electrode. 1 mL of an electron auxiliary layer composition, 1 mL of an inorganic ETL composition, 1 mL of a light-emitting layer composition, 1 mL of a hole transport layer composition, and 1 mL of a hole injection layer composition were coated on the first electrode by a solution process using spin coating.

Specifically, a composition mixing ZnO and functional layer material was spin-coated on the first electrode which is cleaned to form a film having a thickness of 30 nm, and then baked at 200 °C for 10 minutes to form a first electron auxiliary layer. A composition mixing ZnMgO and functional layer was spin-coated on the first electron auxiliary layer to form a film having a thickness of 20 nm, and then baked at 200 °C for 10 minutes to form a second electron auxiliary layer. A light-emitting layer was spin-coated on the second electron auxiliary layer to form a film having a thickness of 20 nm, and then baked at 100 °C for 10 minutes to form the light-emitting layer. A first hole auxiliary layer composition was spin-coated on the layer formed up to the light-emitting layer to form a film having a thickness of 20 nm, and then baked at 100 °C for 10 minutes to form a first hole auxiliary layer. A second hole auxiliary layer composition was spin-coated on the first hole auxiliary layer to form a film having a thickness of 10 nm, and then baked at 100 °C for 10 minutes to form a second hole auxiliary layer. Subsequently, AgMg was vacuum deposited on the second hole auxiliary layer to form a second electrode having a thickness of 10 nm to manufacture a light-emitting element. As a deposition machine, a Suicel plus 200 deposition machine of Sunic System was used. Driving voltage, luminous efficiency, and color coordinates of the light-emitting element manufactured in the comparative example 1 were measured using a Keithley SMU 236 and a luminance meter PR650.

### [Comparative Example 3]

A light-emitting element was manufactured in a same manner as in Experimental Example 1, except that a formation order of the first electron auxiliary layer and the functional layer was changed.

That is, the light-emitting element of Comparative Example 3 was manufactured by forming the first electrode, the functional layer on the first electrode, the first electron auxiliary layer on the functional layer, the second electron auxiliary layer on the first electron auxiliary layer, the light-emitting layer on the second electron auxiliary layer, the first hole auxiliary layer on the light-emitting layer, the second hole auxiliary layer on the first hole auxiliary layer, and the second electrode on the second hole auxiliary layer.

By measuring voltage (Op. V), current efficiency (LE), and external quantum efficiency (EQE) capable of producing desired luminance (1850 nits) of the light-emitting elements manufactured in Comparative Examples 1 to 3 and Experimental Examples 1 and 2, results are shown in Table 1. At this time, Comparative Examples 1 to 3 and Experimental Examples 1 and 2 compare results for a green light-emitting layer.

**[Table 1]**

| | Op. V (V) | LE (cd/A) | CIEx | CIEy | EQE (%) |
|---|---|---|---|---|---|
| Comparative Example 1 | 4.8 | 65.7 | 0.244 | 0.725 | 17.5 |
| Experimental Example 1 | 4.7 | 74.0 | 0.258 | 0.715 | 19.5 |
| Experimental Example 2 | 5.0 | 72.5 | 0.257 | 0.715 | 19.1 |
| Comparative Example 2 | 6.4 | 41.0 | 0.249 | 0.725 | 10.5 |
| Comparative Example 3 | 4.8 | 62.3 | 0.283 | 0.699 | 17.1 |

FIG. 11 is a graph showing current density over voltage. FIG. 12 is a graph showing luminance over time.

Referring to Table 1 and FIGS. 11 and 12, it may be seen that Experimental Examples 1 and 2 show excellent results in both efficiency and lifespan compared to Comparative Examples 1 to 3.

Specifically, referring to Table 1, it may be confirmed that Experimental Examples 1 and 2 have lower voltage (Op. V) capable of producing desired luminance (about 1850 nit) than Comparative Examples 1 to 3. In addition, it may be seen that Experimental Examples 1 and 2 have higher current efficiency (LE) and higher external quantum efficiency (EQE) than Comparative Examples 1 to 3.

Referring to FIG. 11, it may be confirmed that Experimental Examples 1 and 2 are elements having lower resistance than Comparative Example 2, and that they have a similar level of resistance to Comparative Examples 1 and 3.

Referring to FIG. 12, it may be seen that luminance value of Experimental Examples 1 and 2 decreases relatively less with time compared to Comparative Examples 1 to 3. Therefore, it may be confirmed that Experimental Examples 1 and 2 have excellent lifespan compared to Comparative Examples 1 to 3.

Although the present invention has been described with reference to embodiments thereof, it will be understood by those skilled in the art that various modifications and changes may be made to the present invention without departing from the spirit and scope of the present invention as set forth in the claims below.

### Industrial Applicability

The light-emitting element according to embodiments of the present invention may be applied to display devices included in computers, laptops, mobile phones, smart phones, smart pads, automobiles, PMPs, PDAs, MP3 players, or the like.

Although the present invention has been described with reference to embodiments thereof, it will be understood by those skilled in the art that various modifications and changes may be made to the present invention without departing from the spirit and scope of the present invention as set forth in the claims below.

### <Explanation of Reference Number>

| | | | |
|---|---|---|---|
| 10, 11: | light-emitting element | 100: | first electrode |
| 200: | intermediate layer | 300: | second electrode |
| 211: | first electron auxiliary layer | 213: | second electron auxiliary layer |
| 220: | functional layer | 230: | light-emitting layer |
| 240: | first hole auxiliary layer | 250: | second hole auxiliary layer |
| 20: | circuit element layer | 30: | light-emitting element layer |
| 40: | encapsulation layer | 1: | display device |

## Claims

1. A light-emitting element comprising:
a first electrode;
a second electrode facing the first electrode;
a light-emitting layer disposed between the first electrode and the second electrode;
a first electron auxiliary layer disposed between the first electrode and the light-emitting layer; and
a functional layer disposed between the light-emitting layer and the first electron auxiliary layer and including a compound having a carboxyl group.

2. The light-emitting element of claim 1, wherein the compound having the carboxyl group includes any one of following compounds: 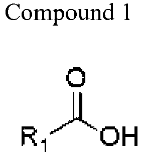 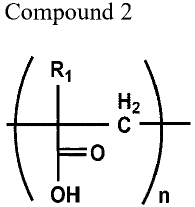 wherein in compound 1 and compound 2, R1 each independently represents

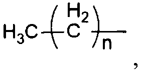

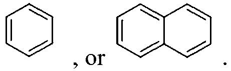

3. The light-emitting element of claim 1, wherein the first electron auxiliary layer includes inorganic metal nano particles.

4. The light-emitting element of claim 3, wherein the first electron auxiliary layer includes at least one selected from TiO₂, ZnO, ZnMgO, ZnAlO, and SnO₂.

5. The light-emitting element of claim 1, further comprising:
a second electron auxiliary layer disposed on the first electron auxiliary layer.

6. The light-emitting element of claim 5, wherein the first electron auxiliary layer is an electron injection layer, and
the second electron auxiliary layer is an electron transport layer.

7. The light-emitting element of claim 5, wherein the first electron auxiliary layer includes ZnO, and the second electron auxiliary layer includes ZnMgO.

8. The light-emitting element of claim 5, wherein the functional layer is disposed between the first electron auxiliary layer and the second electron auxiliary layer.

9. The light-emitting element of claim 8, wherein the functional layer is in direct contact with the first electron auxiliary layer.

10. The light-emitting element of claim 5, wherein the functional layer is disposed between the second electron auxiliary layer and the light-emitting layer.

11. The light-emitting element of claim 10, wherein the functional layer is in direct contact with the second electron auxiliary layer.

12. The light-emitting element of claim 1, wherein the light-emitting layer includes a quantum dot.

13. The light-emitting element of claim 1, wherein the light-emitting layer includes an organic material.

14. The light-emitting element of claim 1, further comprising:
a hole auxiliary layer disposed between the second electrode and the light-emitting layer.

15. A method of manufacturing a light-emitting element, the method comprising:
forming a first electrode;
forming a first electron auxiliary layer on the first electrode;
forming a functional layer including a compound having a carboxyl group on the first electron auxiliary layer;
forming a light-emitting layer on the functional layer; and
forming a second electrode on the light-emitting layer.

16. The method of claim 15, wherein the forming the functional layer includes:
forming a preliminary functional layer including a compound having an ester group on the first electron auxiliary layer; and
heat-treating the preliminary functional layer.

17. The method of claim 16, wherein the compound having the ester group includes any one of following compounds: 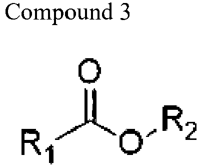 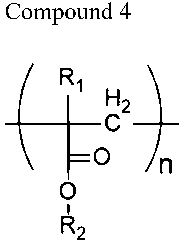 wherein in compound 3 and compound 4,
R1 each independently represents 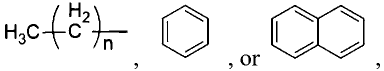 and
R2 each independently represents

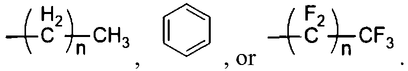

18. The method of claim 16, further comprising:
forming a second electron auxiliary layer on the first electron auxiliary layer, and
wherein the forming the second electron auxiliary layer is performed before the forming the light-emitting layer.

19. The method of claim 18, wherein the functional layer is formed on the first electron auxiliary layer, and
the second electron auxiliary layer is formed on the functional layer.

20. The method of claim 18, wherein the functional layer is formed on the second electron auxiliary layer.
